# EUROPEAN PATENT SPECIFICATION

(11) **EP 1 869 717 B1**
(45) Date of publication and mention of the grant of the patent: **04.01.2017**
(21) Application number: 06731726.3
(22) Date of filing: 06.04.2006
(51) Int. Cl.: H01L 33/00, H01S 5/323, H01L 21/02

(54) **PRODUCTION METHOD OF GROUP III NITRIDE SEMIOCONDUCTOR ELEMENT**
HERSTELLUNGSVERFAHREN FÜR EIN GRUPPE-III-NITRID-HALBLEITERELEMENT
PROCÉDÉ DE PRODUCTION D'UN ÉLÉMENT SEMI-CONDUCTEUR À BASE D'UN NITRURE DU GROUPE III

(30) Priority: 07.04.2005 JP 2005110915; 12.05.2005 JP 2005139596
(43) Date of publication of application: 26.12.2007
(73) Proprietor: Toyoda Gosei Co., Ltd., Aichi 452-8564 (JP)
(72) Inventor: TAKEDA, Hitoshi, Nagoya-shi, Aichi 468-0004 (JP)
(74) Representative: Strehl Schübel-Hopf & Partner
(86) International application number: PCT/JP2006/307790
(87) International publication number: WO 2006/109840

(56) References cited:
- WO-A1-02/17369
- JP-A- 10 149 992
- JP-A- 10 173 288
- JP-A- 10 214 959
- JP-A- 2001 057 442
- JP-A- 2001 168 045
- JP-A- 2001 196 702
- JP-A- 2003 197 541
- JP-A- 2003 218 469
- JP-A- 2004 055 741
- US-A- 6 147 363
- US-A1- 2004 227 152

## Description

### Technical Field

The present invention relates to a production method of a Group III nitride semiconductor element which exhibits good reliability and which is employed in, for example, light-emitting diodes, laser diodes, and light-receiving devices.

### Background Art

Group III nitride semiconductors have a direct transition band structure and exhibit bandgap energies corresponding to the energy of visible to ultraviolet light. By virtue of these characteristics, Group III nitride semiconductors are employed at present for producing light-emitting devices, including blue LEDs, blue-green LEDs, ultraviolet LEDs, and white LEDs which contain a fluorescent substance in combination with such a nitride semiconductor.

Growing only a nitride single crystal itself has been considered difficult, for the following reasons. Nitrogen, which is a constituent of the single crystal, has high dissociation pressure and, therefore, is not retained in a single crystal in, for example, the Czochralski method.

Therefore, a Group III nitride semiconductor is generally produced by means of metal organic chemical vapor deposition (MOCVD). In this technique, a single-crystal substrate is placed on a heatable jig provided in a reaction space, and raw material gases are fed onto the surface of the substrate, to thereby grow, on the substrate, an epitaxial film of nitride semiconductor single crystal. The single-crystal substrate is formed of, for example, sapphire or silicon carbide (SiC). However, even when a nitride semiconductor single crystal is grown directly on such a single-crystal substrate, many crystal defects, which are attributed to crystal lattice mismatch between the crystalline substrate and the single crystal, are generated in the resultant nitride semiconductor single crystal film; i.e., the epitaxial film fails to exhibit good crystallinity. In view of the foregoing, there have been proposed several methods for growing, between a substrate and a nitride semiconductor single crystal epitaxial film, a layer having a function for suppressing generation of crystal defects (i.e., a layer corresponding to a buffer layer), so as to attain good crystallinity of the epitaxial film.

In one typical method, an organometallic raw material and a nitrogen source are simultaneously fed onto a substrate at a temperature of 400 to 600°C, to thereby form a low-temperature buffer layer; the thus-formed buffer layer is subjected to thermal treatment (i.e., crystallization) at an increased temperature; and a target Group III nitride semiconductor single crystal is epitaxially grown on the resultant buffer layer (see Japanese Laid-Open Patent Application (*kokai*) No. 2-229476). Also, there has been proposed a method including a first step of depositing fine Group III metal particles onto the surface of a substrate; a second step of nitridizing the fine particles in an atmosphere containing a nitrogen source; and a third step of growing a target Group III.nitride semiconductor single crystal on the thus-nitridized fine particles (see International Publication WO 02/17369 Pamphlet). Such a method can produce a Group III nitride semiconductor single crystal exhibiting somewhat good crystallinity.

Also, with an aim to further improve the performance of a semiconductor element, it is proposed that a growth of the semiconductor is interrupted during or/and after growth of an active layer in order to enhance the crystallinity of the active layer and make the thickness of the active layer uniform (see, for example, Japanese Laid-Open Patent Application (kokai) No. 2001-57442 and Japanese Laid-Open Patent Application (kokai) No. 2003-218034).

Important factors for evaluating the performance of a semiconductor light-emitting device are, for example, emission wavelength, emission intensity and forward voltage under application of rated current, and reliability of the device. A key indicator for determining such reliability is an electrostatic discharge property. In recent years, demand has arisen for a semiconductor light-emitting device exhibiting an excellent electrostatic discharge property, in the electronic industry.

US 6 147 363 A and US 2004/227152 A1 disclose a production method of a Group III nitride semiconductor element having, on a substrate, in this order, an n-type layer, an active layer and a p-type layer, wherein the growth rate of the semiconductor is reduced after growth of the n-type layer.

### Disclosure of Invention

An object of the present invention is to provide a production method of a Group III nitride semiconductor element having an excellent electrostatic discharge property and enhanced reliability.

The present invention is defined by the appended claims 1-6.

A Group III nitride semiconductor element having an excellent electrostatic discharge property and enhanced reliability is obtained according to the present invention, in which, as the essential features of the invention, during growth of an n-type layer and before growth of an active layer, a growth rate of a semiconductor is reduced.

It is not clear why the electrostatic discharge property can be improved by reducing a growth rate of the semiconductor during growth of an n-type layer and before growth of an active layer. However, it is assumed that a surface of the n-type layer formed previously is flattened by reducing the growth rate of the semiconductor and, thereby, the crystallinity of a semiconductor layer to be formed thereafter is improved. Nevertheless, the present invention is not limited to this idea.

### Brief Description of Drawings

Fig. 1 is a schematic diagram showing the cross-sectional structure of a typical Group III nitride semiconductor light-emitting device.
Fig. 2 is a schematic diagram showing the cross-sectional structure of the inventive Group III nitride semiconductor light-emitting device fabricated in Example 1.

### Best Mode for Carrying out the Invention

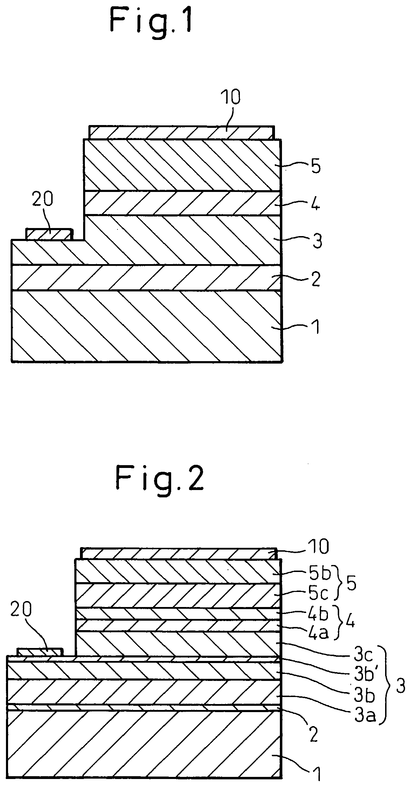

As for a Group III nitride semiconductor element, a structure is well known, in which, as shown in Fig. 1, on a substrate 1, a buffer layer 2, an n-type layer 3, an active layer 4 and a p-type layer 5 are crystal-grown sequentially; the active layer 4 and the p-type layer are partly removed by etching and the n-type layer is exposed; and both an positive electrode 10 on the remaining p-type layer 5 and a negative electrode 20 on the exposed n-type layer 3 are formed. A production method according to the present invention can be unrestrictedly used for a Group III nitride semiconductor light-emitting device having the above structure.

As for a substrate, an oxide single crystal such as a sapphire single crystal (Al₂O₃; A plane, C plane, M plane, R plane), a spinel single crystal (MgAl₂O₄), a ZnO single crystal, a LiAlO₂ single crystal, a LiGaO₂ single crystal or a MgO single crystal, a Si single crystal, a SiC single crystal, a GaAs single crystal, a AlN single crystal, a GaN single crystal, a boron compound single crystal such as ZrB2, etc. are well known as substrate materials. In the present invention, any substrate material including the above well-known substrate materials can be used without any restrictions. Among these, a sapphire single crystal and a SiC single crystal are preferred. A plain direction of the substrate is not limited. The crystal plane of the substrate may be inclined toward to a specific crystal plane or may not be inclined.

On a substrate, through a buffer layer as disclosed in the above-mentioned Japanese Laid-Open Patent Application (kokai) No. 2-229476 and International Publication WO 02/17369 Pamphlet, an n-type layer, an active layer and a p-type layer, which comprise a Group III nitride semiconductor, are usually stacked. The buffer layer may not be necessary depending on a substrate used or a growth condition of an epitaxial layer.

Numerous Group III nitride semiconductors are known, such as those represented by the general formula Al_{X}Ga_{Y}In_{Z}N_{1-A}M_{A} (0≤X≤1, 0≤Y≤1, 0≤Z≤1 and X+Y+Z=1, wherein M represents a Group V element different from nitrogen (N), and 0≤A≤1) and, according to the invention, there may be used, without any particular restrictions, Group III nitride semiconductors represented by the general formula Al_{X}Ga_{Y}In_{Z}N_{1-A}M_{A} (0≤X≤1, 0≤Y≤1, 0≤Z≤1, X+Y+Z=1. M represents a Group V element different from nitrogen (N) and 0≤A<1), which include the aforementioned well-known Group III nitride semiconductors.

The Group III nitride semiconductor may contain other Group III elements in addition to Al, Ga and In and, if necessary, elements such as Ge, Si, Mg, Ca, Zn, Be, P, As and B may be included. These are not limited to intentionally added elements, and may be unavoidable impurities which depend on the film-forming conditions, etc. or trace impurities included in the starting materials and reactor materials.

There are no particular restrictions on the growth method for the Group III nitride semiconductor, and any method known to grow a Group III nitride semiconductor may be applied, such as MOCVD (metal-organic chemical vapor deposition), HVPE (hybrid vapor phase epitaxy) or MBE (molecular beam epitaxy). MOCVD is a preferred growth method from the standpoint of film thickness control and productivity. In MOCVD, hydrogen (H₂) or nitrogen (N₂) is used as the carrier gas, trimethylgallium (TMGa) or triethylgallium (TEGa) is used as the Ga source (Group III material), trimethylaluminum (TMAl) or triethylaluminum (TEAl) is used as the Al source (Group III material), trimethylindium (TMIn) or triethylindium (TEIn) is used as the In source (Group III material), and ammonia (NH₃) or hydrazine (N₂H₄) is used as the N source (Group V material). The dopant used, for the n-type layer, may be monosilane (SiH₄) or disilane (Si₂H₆) as the Si source and germane gas (GeH₄) or an organic germanium compound such as tetramethylgermanium ((CH₃)₄Ge) or tetraethylgermanium ((C₂H₅)₄Ge) as the Ge source, for the n-type layer. In MBE, elemental germanium may be utilized as the doping source. For the p-type layer, for example, biscyclopentadienylmagnesium (Cp₂Mg) or bisethylcyclopentadienylmagnesium ((EtCp)₂Mg) is used as the Mg source.

The n-type layer is composed of an undercoat layer, n-type contact layer and n-type clad layer. The n-type contact layer may also serve as the undercoat layer and/or the n-type clad layer. The undercoat layer is preferably composed of an Al_{X}Ga_{1-X}N layer (0≤x≤1, preferably 0≤x≤0.5, more preferably 0≤x≤0.1). The thickness is preferably at least 0.1 µm, more preferably at least 0.5 µm and even more preferably at least 1 µm. A thickness above this range will tend to yield an Al_{X}Ga_{1-X}N layer with satisfactory crystallinity. The upper limit for the thickness of the undercoat layer is not particularly restricted for the purpose of the invention.

The undercoat layer may be doped with an n-type impurity in the range of 1 x 10¹⁷ - 1 x 10¹⁹/cm³, but an undoped layer (<1 x 10¹⁷/cm³) is preferred from the standpoint of maintaining satisfactory crystallinity. There are no particular restrictions on the n-type impurity, and as examples there may be mentioned Si, Ge and Sn, among which Si and Ge are preferred.

The growth temperature for growth of the undercoat layer is preferably 800-1200°C and more preferably 1000-1200°C. Growth within this growth temperature range will result in satisfactory crystallinity. The pressure in the MOCVD epitaxy reactor is adjusted to 15-40 kPa.

The n-type contact layer is preferably composed of an Al_{X}Ga_{1-X}N layer (0≤x≤1, preferably 0≤x≤0.5, more preferably 0≤x≤0.1), similarly to the undercoat layer. It is preferably doped with an n-type impurity, and preferably the n-type impurity concentration is 1 x 10¹⁷ - 1 x 10¹⁹/cm³ and more preferably 1 x 10¹⁸ - 1 x 10¹⁹/cm³, from the standpoint of maintaining satisfactory ohmic contact with the negative electrode, controlling generation of cracks and maintaining satisfactory crystallinity. There are no particular restrictions on the n-type impurity, and as examples there may be mentioned Si, Ge and Sn, among which Si and Ge are preferred. The growth temperature is similar to that of the undercoat layer.

The Group III nitride semiconductors composing the undercoat layer and n-type contact layer preferably have the same composition, and the total thickness is preferably set within a range of 1-20 µm, more preferably 2-15 µm and even more preferably 3-12 µm. A thickness within this range is preferred from the standpoint of maintaining satisfactory crystallinity.

An n-type clad layer is preferably provided between the n-type contact layer and light-emitting layer, because it can fill areas of distorted flatness of the outermost surface of the n-type contact layer. The n-type clad layer contains In and may be formed of GaInN or the like. There may also be formed a super lattice structure as a hetero-junction or multiple lamination of these structures. When GaInN is used, it is naturally preferred for it to have a larger band gap than the GaInN of the light-emitting layer.

The thickness of the n-type clad layer is not particularly restricted, but is preferably 0.005-0.5 µm and more preferably 0.005-0.1 µm. The n-type dope concentration of the n-type clad layer is preferably 1 x 10¹⁷ - 1 x 10²⁰/cm³ and more preferably 1 x 10¹⁸ - 1 x 10¹⁹/cm³. A dope concentration within this range is preferred from the standpoint of maintaining satisfactory crystallinity and lowering the operating voltage of the device.

A growth rate of the semiconductor is reduced during growth of an n-type layer
and before growth of an active layer. The reduction of growth rate may be carried out more than once. The reduction of the growth rate may be carried out for any one of an undercoat layer, an n-type contact layer and an n-type clad layer.since the n-type clad layer contains In, the reduction of the growth rate is preferably carried out during growth of the n-type contact layer and before growth of the n-type clad layer, because, if a substrate temperature is increased, In in the n-type clad layer might be decomposed and sublimated during reducing the growth rate.

The reduced growth rate is preferably less than 1µm/hr. If the reduced growth rate is not less than 1µm/hr, an effect on improvement in a surface flatness cannot be obtained. The reduced growth rate is more preferably not more than 0.7 µm/hr, and most preferably not more than 0.5 µm/hr.

Any method can be used as a method for reducing the growth rate. Examples of the method include reducing an amount of a III group raw material, increasing a growth temperature excessively, increasing a flow rate of a carrier gas, etc. Among these, reducing an amount of a III group material is preferably used. A nitrogen source could be reduced at the same time. However, if the nitrogen source is reduced, the semiconductor grown previously might be decomposed. Accordingly, it is preferable to continue supplying the nitrogen source above a certain level during reducing the growth rate. A flow rate of the nitrogen source, such as NH₃, is preferably 1 to 20 litter/min. If the flow rate of the nitrogen source is not more than 1 litter/min, the semiconductor grown previously might be decomposed. If the flow rate of the nitrogen source is more than 20 litter/min, the difference of the advantage is small and only the cost increases. The flow rate of the nitrogen source is more preferably 3 to 18 litter/min and most preferably 5 to 15 litter/min. A flow rate ratio to a carrier gas is preferably less than 1, more preferably less than 2/3, most preferably less than 1/2.

Similarly, the growth interruption is preferably carried out by stopping supplying the III group raw material. The nitrogen source could be reduced at the same time. However, if the nitrogen source is reduced, the semiconductor grown previously might be decomposed. Accordingly, it is preferable to continue supplying the nitrogen source during interrupting the growth. The flow rate of the nitrogen source, such as NH₃, was mentioned above.

A carrier gas is preferably a mixture gas of H₂ and N₂ in the same way as general growth of n-type layer. An H₂-riched gas, (namely, a flow rate ratio of H₂ to N₂ is more than 1), is preferred, because crystallinity of a semiconductor to be formed is improved. The flow rate ratio of H₂ to N₂ is more preferably more than 1.5 and most preferably more than 2.

In short, the reduction of the semiconductor growth rate is preferably carried out by continuing flowing a carrier gas and a nitrogen source and reducing an amount of a III group raw material.

The substrate temperature during reducing the growth rate is kept not lower than the substrate temperature in the course of growth of an n-type layer immediately before the growth rate is reduced. If the substrate temperature during reducing the growth rate is lower than the substrate temperature in the course of growth of an n-type layer immediately before the growth rate is reduced, the electrostatic discharge property is less improved. The substrate temperature during reducing the growth rate is 900 to 1400 °C. If the substrate temperature is less than 900 °C, the electrostatic discharge property is less improved. If the substrate temperature is more than 1400 °C, crystallinity of a semiconductor layer grown previously is deteriorated or surface flatness of a semiconductor layer grown previously is reduced, thus resulting in the deterioration in crystallinity of a semiconductor layer formed thereon.

A thickness of the reduced-growth-rate layer in which a growth rate of the semiconductor is reduced is preferably not more than 100 nm. If the growth is carried out at a thickness of more than 100 nm, the productivity is decreased and a further enhancement of the electrostatic discharge property cannot be expected. The thickness of the reduced-growth-rate layer is more preferably not more than 75 nm and most preferably not more than 50 nm.

A time period for reducing the growth rate of the semiconductor is preferably 30 seconds to 4 hours. If the time period is less than 30 seconds, the electrostatic discharge property is hardly improved. If the reduction is carried out for more than 4 hours, the productivity is decreased and a further enhancement of the electrostatic discharge property cannot be expected. The time period for reducing the growth rate of the semiconductor is more preferably 5 minutes to 1 hour and 30 minutes, and most preferably 15 minutes to 1 hour.

As for the active layer which is stacked on the n-type layer, a Group III nitride semiconductor, and preferably the Group III nitride semiconductor Ga₁₋ₛInₛN (0<s<0.4), is generally employed in the present invention. The thickness of the active layer is not particularly restricted, but a thickness obtained by a quantum effect, i.e. a critical film thickness, is suitable, and the thickness is preferably, for example, 1-10 nm and more preferably 2-6 nm. A thickness within this range is preferred from the standpoint of emission output. The active layer may have a single quantum well (SQW) structure as described above, or a multiple quantum well (MQW) structure comprising the aforementioned Ga₁₋ₛInₛN as the well layer and an Al_{c}Ga_{1-c}N (0≤c<0.3 and b>c) barrier layer with a larger band gap energy than the well layer. The well layer and barrier layer may also be doped with impurities.

The growth temperature of the Al_{c}Ga_{1-c}N barrier layer is preferably a temperature of at least 700°C and more preferably 800-1100°C, for satisfactory crystallinity. The GaInN well layer is preferably grown at 600-900°C and more preferably 700-900°C. That is, the growth temperature is preferably varied between layers for satisfactory MQW crystallinity.

The p-type layer is normally composed of a p-type clad layer and a p-type contact layer. The p-type contact layer may also serve as the p-type clad layer. The p-type clad layer is not particularly restricted so long as it has a composition with a larger band gap energy than the active layer and encloses the carrier in the active layer, but it is preferably Al_{d}Ga_{1-d}N (0<d≤0.4, preferably 0.1≤d≤0.3). A p-type clad layer composed of this type of AlGaN is preferred from the standpoint of enclosing the carrier in the active layer. The thickness of the p-type clad layer is not particularly restricted, but is preferably 1-400 nm and more preferably 5-100 nm. The p-type dope concentration of the p-type clad layer is preferably 1 x 10¹⁸ - 1 x 10²¹/cm³ and more preferably 1 x 10¹⁹ - 1 x 10²⁰/cm³. A p-type dope concentration within this range will yield a satisfactory p-type crystal without a reduction in crystallinity.

The p-type contact layer is a Group III nitride semiconductor layer comprising at least AlₑGa₁₋ₑN (0≤e<0.5, preferably 0≤e≤0.2, more preferably 0≤e≤0.1). An Al composition within this range is preferred from the standpoint of maintaining satisfactory crystallinity and satisfactory ohmic contact with the positive electrode. A p-type dopant concentration of 1 x 10¹⁸ - 1 x 10²¹/cm³ and especially 5 x 10¹⁹ - 5 x 10²⁰/cm³ is preferred from the standpoint of maintaining satisfactory ohmic contact, preventing generation of cracks and maintaining satisfactory crystallinity. The p-type impurity is not particularly restricted, but Mg, for example, is preferred. The thickness is also not particularly restricted, but is preferably 0.01-0.5 µm and more preferably 0.05-0.2 µm. A thickness within this range is preferred from the standpoint of emission output.

The n-type contact layer and the p-type contact layer are provided with a negative electrode and a positive electrode, respectively, by well-known means employed in this technical field. The structure of each may be any structure including conventionally publicly known structures, without any restrictions.

Because a Group III nitride semiconductor element produced in the present invention has an excellent electrostatic discharge property, the yield is improved when a light-emitting device or a light-receiving device is produced using the element. Reliability of an electronic device (e.g., a cell phone, a display panel, an instrument panel) in which a chip produced using the above technology is installed; and of a car, a computer, a game console or the like, in which an electronic device is installed, is improved.

### Examples

The present invention will now be explained in greater detail through examples and comparative examples.

### (Example 1)

Fig. 2 is a schematic diagram showing the cross-sectional structure of the Group III nitride semiconductor light-emitting device fabricated in this example.

A stacked structure including a sapphire substrate 1 and Group III nitride semiconductor layers successively stacked on the substrate 1 was formed by means of conventional low-pressure MOCVD through the following procedure. Firstly, a (0001)-sapphire substrate 1 was placed on a high-purity graphite (for semiconductor) susceptor to be heated at a film formation temperature by a high-frequency (RF) induction heater. The sapphire substrate placed on the susceptor was placed in a stainless steel-made vapor-phase epitaxy reactor, and the reactor was purged with nitrogen.

After passage of nitrogen in the vapor-phase epitaxy reactor for 8 minutes, the substrate 1 was heated over 10 minutes from room temperature to 600°C by means of the induction heater. While the substrate 1 was maintained at 600°C, hydrogen gas and nitrogen gas were caused to flow in the vapor-phase epitaxy reactor so as to adjust the pressure inside the reactor to 1.5 x 10⁴ Pa. The surface of the substrate 1 was thermally cleaned by allowing the substrate to stand for 2 minutes under these temperature/pressure conditions. After completion of thermal cleaning, the supply of nitrogen gas was stopped, but hydrogen was continuously supplied to the reactor.

Subsequently, the substrate 1 was heated to 1,120°C in hydrogen. After confirmation that a constant temperature of 1,120°C was attained, hydrogen gas containing trimethylaluminum (TMA) vapor was supplied to the vapor-phase epitaxy reactor for 8 minutes and 30 seconds. Through this step, the supplied TMA was caused to react with N atoms which had been released through decomposition of nitrogen-containing deposits on an inner wall of the reactor, thereby depositing a buffer layer 2 composed of aluminum nitride (AlN) thin film having a thickness of several nm on the sapphire substrate 1. Supply of hydrogen gas containing TMA vapor into the vapor-phase epitaxy reactor was stopped, thereby completing growth of AlN. The conditions were maintained for 4 minutes, whereby the TMA vapor remaining in the reactor was completely removed.

Subsequently, an ammonia (NH₃) gas was supplied into a vapor-phase epitaxy reactor at 15 litter/min. After a lapse of 4 minutes, a susceptor temperature was decreased to 1040 °C with the ammonia gas flowing. After the susceptor temperature was confirmed to be 1040 °C, the temperature was stabilized. Then, supplying trimethyl gallium (TMG) into the vapor-phase epitaxy reactor was started and an undercoat layer 3a comprising an un-doped GaN was grown for 1 hour. A thickness of the undercoat layer 3a was determined to be 2 µm. At the time, H₂ and N₂ were used as a carrier gas. A flow rate ratio of H₂ to N₂ was 5 and a total flow rate was 40 litter/min.

Subsequently, the substrate temperature was increased to 1120 °C and stabilized. Then, tetramethyl germanium ((CH₃)₄Ge) was supplied for 18 seconds and was stopped for 18 seconds. The cycle was repeated 100 times. An n-type contact layer 3b, which has a thickness of 2.0 µm and comprises Ge-doped GaN in which a concentration of Ge changes periodically and a layer at a high Ge concentration and a layer at a low Ge concentration were stacked alternately, was formed. An average carrier concentration in the whole n-type contact layer was 5 × 10¹⁸ cm⁻³.

After the growth of the n-type contact layer 3b, a reduced-growth-rate layer 3b', in which the growth rate was reduced, was grown at a growth rate of 0.06µm/hr for 30 minutes (namely a thickness is 30 nm) by only reducing the supply of TMG and (CH₃)₄Ge into the vapor-phase epitaxy reactor without changing the growth temperature, the flow rate of a carrier gas and the flow rate an ammonia.

After the reduced-growth-rate layer 3b' was grown, an n-type clad layer 3c comprising an un-doped In_{0.03}Ga_{0.97}N was stacked at a temperature of 750 °C. The n-type clad layer 3c was grown using triethyl gallium (TEG) as a gallium source and trimethyl indium (TMI) as an indium source. A thickness of the layer was determined to be 18 nm.

Subsequently, the temperature of the substrate 1 was set to be 730 °C and a multiple quantum well structure active layer 4 having a 5-cycle structure containing six layers of barrier layer 4a comprising GaN and five layers of well layer 4b comprising In_{0.25}Ga_{0.75}N was provided on the clad layer 3c. In the multiple quantum well structure active layer 4, at first, a barrier layer 4a was provided and joined with the n-type clad layer 3c.

The barrier layer 4a comprising GaN was grown using the triethyl gallium (TEG) as a gallium source. The layer possessed a thickness of 8 nm and was not doped. The well layer 4b comprising In_{0.25}Ga_{0.75}N was grown using the triethyl gallium (TEG) as a gallium source and the trimethyl indium (TMI) as an indium source. The layer possessed a thickness of 2.5 nm and was not doped.

On the active layer 4 of the multiple quantum well structure, there was formed a p-type clad layer 5c comprising Al_{0.07}Ga_{0.93}N doped with magnesium (Mg). The layer thickness was 10 nm. On the p-type clad layer 5c, there was further formed a p-type contact layer 5b comprising GaN doped with Mg. A bis-cyclopentadienyl Mg was used as a source for doping with Mg. Mg was so added that the concentration of positive holes in the p-type contact layer 5b was 8 x 10¹⁷ cm⁻³. The thickness of the p-type contact layer 5b was 170 nm.

After the growth of the p-type contact layer 5b finished, supply of electric power to the induction heater was discontinued, and the substrate 1 was permitted to cool down to room temperature over about 20 minutes. While the temperature was lowering, the atmosphere in the vapor-phase epitaxy reactor was constituted of nitrogen only. After having confirmed that the temperature of the substrate 1 had dropped down to room temperature, the stacked structure was taken out from the vapor-phase epitaxy reactor. At this moment, the above p-type contact layer 5b already exhibited p-type conductivity even without effecting the annealing for electrically activating the p-type carrier (Mg).

Next, by utilizing a known photolithography technology and a general dry-etching technology, a layer containing Ge atoms at a high concentration in the n-type contact layer 3b was exposed at a region where a negative electrode 20 was to be formed. On the exposed surface of the layer containing Ge atoms at a high concentration, there was formed the negative electrode 20 laminating titanium and gold thereon (titanium was on the semiconductor side). By utilizing a general vacuum evaporation means and a known photolithography means, on the whole surface of the remaining p-type contact layer 5b of the stacked structure, there was formed the positive electrode 10 by successively laminating platinum and gold from the semiconductor side.

Thereafter, the stacked structure was cut into LED chips of a square shape (350 µm × 350 µm), and each chip was placed on a lead frame to which a gold wire was bonded for allowing device operation current to flow from the lead frame to the LED chip.

Upon passage of a forward current between the negative electrode 20 and the positive electrode 10 via the lead frame, the chip exhibited forward voltage of 3.5 V at a forward current of 20 mA. The emission peak wavelength of the band of blue light emission at a forward current of 20 mA was found to be 460 nm. The emission intensity of the light emitted from the chip, as determined through a typical integrating sphere, was 5 mW. Thus, a Group III nitride semiconductor light-emitting device attaining a high emission intensity was successfully fabricated.

An electrostatic discharge measurement (ESD) using a Human Body Model (HB model) revealed that all 20 points, of the 20 points on a surface of the obtained light-emitting device, had an electrostatic breakdown voltage of not less than 2000 V.

### (Example 2)

A light-emitting device of a Group III nitride semiconductor was formed in a similar way to Example 1, except that, after the n-type contact layer 3b was grown, supplying of TMG and (CH₃)₄Ge into a vapor-phase epitaxy reactor was completely stopped, without changing the growth temperature, the flow rate of a carrier gas and the flow rate of an ammonia gas. Therefore, there was no reduced-growth-rate layer 3b' in this example.

The obtained light-emitting device was evaluated in the same manner as in Example 1. The chip exhibited forward voltage of 3.5 V at a forward current of 20 mA. The emission peak wavelength of the band of blue light emission at a forward current of 20 mA was found to be 460 nm. The emission intensity of the light emitted from the chip, as determined through a typical integrating sphere, was 5 mW. Thus, a Group III nitride semiconductor light-emitting device attaining a high emission intensity was successfully fabricated. In the electrostatic discharge measurement (ESD), all 20 points, of the 20 points on a surface of the obtained light-emitting device, had an electrostatic breakdown voltage of not less than 2000 V.

### (Example 3)

A Group III nitride semiconductor light-emitting device was formed in a similar way to example 2, except that after an n-type contact layer was grown to half of the total thickness, i.e., after 50 cycles, each cycle consisting of supply of tetramethyl germanium ((CH₃)₄Ge) for 18 seconds and interruption of supply for 18 seconds, were repeatedly conducted, supplying of TMG and ((CH₃)₄Ge) into a vapor-phase epitaxy reactor was completely stopped for 30 minutes, without changing the growth temperature, the flow rate of a carrier gas and the flow rate of an ammonia gas. Namely, in this example, growth of a semiconductor layer was interrupted twice, during growth and immediately after growth of the n-type contact layer 3b.

The obtained light-emitting device was evaluated in the same manner as in Example 1. The chip exhibited forward voltage of 3.5 V at a forward current of 20 mA. The emission peak wavelength of the band of blue light emission at a forward current of 20 mA was found to be 460 nm. The emission intensity of the light emitted from the chip, as determined through a typical integrating sphere, was 5.2 mW. Thus, a Group III nitride semiconductor light-emitting device attaining a high emission intensity was successfully fabricated. In the electrostatic discharge measurement (ESD), all 20 points, of the 20 points on a surface of the obtained light-emitting device, had an electrostatic breakdown voltage of not less than 2000 V.

### (Comparative Example)

A Group III nitride semiconductor light-emitting device was produced in a similar way to Example 1, except that immediately after growth of the n-type contact layer 3b, a substrate temperature was decreased to 750 °C and a growth of the n-type clad layer 3c was carried out.

The obtained light-emitting device was evaluated in the same manner as in Example 1. The chip exhibited forward voltage of 3.5 V at a forward current of 20 mA. The emission peak wavelength of the band of blue light emission at a forward current of 20 mA was found to be 460 nm. The emission intensity of the light emitted from the chip, as determined through a typical integrating sphere, was 5 mW. Thus, a Group III nitride semiconductor light-emitting device attaining a high emission intensity was successfully fabricated. In the electrostatic discharge measurement (ESD), however, only 3 points, of the 20 points on a surface of the obtained light-emitting device, had an electrostatic breakdown voltage of not less than 2000 V.

### Industrial Applicability

A Group III nitride semiconductor element produced in to the present invention makes it possible to produce a stable device having an excellent electrostatic discharge property, if it is applied to a light-emitting device such as a light-emitting diode or a laser diode and a light-receiving device, etc. Therefore, it has a great potential in the industry.

## Claims

1. A production method of a Group III nitride semiconductor element having, on a substrate (1), in this order, an n-type layer (3), an active layer (4) and a p-type layer (5) which comprise a Group III nitride semiconductor, wherein the n-type layer (3) is composed of an undercoat layer (3a), n-type contact layer (3b) and n-type clad layer (3c), the n-type clad layer (3c) containing In, during growth of the n-type contact layer (3b) and before growth of the n-type clad layer (3c), the growth rate of the semiconductor is reduced, and the active layer (4) is successively grown after growth of the n-type clad layer (3c), wherein the substrate temperature during reducing the growth rate is not lower than the substrate temperature in the course of growth of the n-type layer immediately before the growth rate is reduced, and the substrate temperature during reducing the growth rate is 900 to 1400°C.

2. The production method according to claim 1, wherein a reduced growth rate of the Group III nitride semiconductor is less than 1 µm/hr.

3. The production method according to claim 1, wherein a time period for reducing the growth rate is not less than 30 seconds and not more than 4 hours.

4. The production method according to claim 1, wherein the thickness of the reduced-growth-layer, in which a growth rate of the semiconductor is reduced, is not more than 100 nm.

5. The production method according to claim 1, wherein the growth of the Group III nitride semiconductor is carried out by MOCVD and a carrier gas used in the MOCVD is a mixture gas of H₂ and N₂.

6. The production method according to claim 1, wherein the method comprises supplying NH₃ as a nitrogen source at a flow rate of 1 to 20 liter/min during reduction of the growth rate.

## Patentansprüche

1. Verfahren zum Herstellen eines Gruppe III-Nitridhalbleiterelements, das auf einem Substrat (1) in dieser Reihenfolge eine n-Typ-Schicht (3), eine aktive Schicht (4) und eine p-Typ-Schicht (5) aufweist, die einen Gruppe III-Nitridhalbleiter umfassen, wobei die n-Typ-Schicht (3) aus einer Unterschicht (3a), einer n-Typ-Kontaktschicht (3b) und einer n-Typ-Abdeckschicht (3c) zusammengesetzt ist, wobei die n-Typ-Abdeckschicht (3c) In enthält, während des Wachstums der n-Typ-Kontaktschicht (3b) und vor dem Wachstum der n-Typ-Abdeckschicht (3c) die Wachstumsrate des Halbleiters verringert ist und die aktive Schicht (4) nach dem Wachstum der n-Typ-Abdeckschicht (3c) gezüchtet wird, wobei die Substrattemperatur während der Verringerung der Wachstumsrate nicht geringer ist als die Substrattemperatur im Verlauf des Wachstums der n-Typ-Schicht unmittelbar vor der Verringerung der Wachstumsrate, und die Substrattemperatur während der Verringerung der Wachstumsrate 900 bis 1400°C ist.

2. Herstellungsverfahren nach Anspruch 1, wobei eine verringerte Wachstumsrate des Gruppe III-Nitridhalbleiters weniger als 1 µm/h ist.

3. Herstellungsverfahren nach Anspruch 1, wobei ein Zeitraum für die Verringerung der Wachstumsrate nicht weniger als 30 Sekunden und nicht mehr als 4 Stunden ist.

4. Herstellungsverfahren nach Anspruch 1, wobei die Dicke der Schicht bei verringertem Wachstum, bei dem die Wachstumsrate des Halbleiters verringert ist, nicht mehr als 100 nm ist.

5. Herstellungsverfahren nach Anspruch 1, wobei das Produzieren des Gruppe III-Nitridhalbleiters durch MOCVD durchgeführt wird und ein in dem MOCVD-Verfahren eingesetztes Trägergas ein Gemisch von H₂ und N₂ ist.

6. Herstellungsverfahren nach Anspruch 1, wobei das Verfahren das Zuführen von NH₃ als Stickstoffquelle bei einer Fließgeschwindigkeit von 1 bis 20 Liter/min während der Verringerung der Wachstumsrate umfasst.

## Revendications

1. Procédé de production d'un élément semi-conducteur à base d'un nitrure du groupe III présentant, sur un substrat (1), dans cet ordre, une couche de type n (3), une couche active (4) et une couche de type p (5) qui comprend un semi-conducteur à base d'un nitrure du groupe III, dans lequel la couche de type n (3) est composée d'une sous-couche de fond (3a), d'une couche de contact de type n (3b) et d'une couche de gainage de type n (3c), la couche de gainage de type n (3c) contenant de l'In, pendant la croissance de la couche de contact de type n (3b) et avant la croissance de la couche de gainage de type n (3c), le taux de croissance du semi-conducteur est réduit, et la couche active (4) croît successivement après la croissance de la couche de gainage de type n (3c), dans lequel la température du substrat pendant la réduction du taux de croissance n'est pas inférieure à la température du substrat pendant la croissance de la couche de type n immédiatement avant que le taux de croissance soit réduit, et la température du substrat pendant la réduction du taux de croissance est comprise entre 900°C et 1400°C.

2. Procédé de production selon la revendication 1, dans lequel un taux de croissance réduit du semi-conducteur à base d'un nitrure du groupe III est inférieur à 1 µm/heure.

3. Procédé de production selon la revendication 1, dans lequel une période de temps pour réduire le taux de croissance n'est pas inférieure à 30 secondes et pas supérieure à 4 heures.

4. Procédé de production selon la revendication 1, dans lequel l'épaisseur de la couche à croissance réduite, dans laquelle un taux de croissance du semi-conducteur est réduit, n'est pas supérieure à 100 nm.

5. Procédé de production selon la revendication 1, dans lequel la croissance du semi-conducteur à base d'un nitrure du groupe III est exécutée par un procédé de déposition en phase vapeur de produit chimique métallo-organique (MOCVD), et un gaz porteur utilisé dans le procédé MOCVD est un mélange gazeux de H₂ et de N₂.

6. Procédé de production selon la revendication 1, dans lequel le procédé comprend la fourniture de NH₃ comme source d'azote à un débit compris entre 1 et 20 litre(s) par minute pendant la réduction du taux de croissance.
